Europäisches Patentamt

European Patent Office

Office européen des brevets

(19)

(11) Publication number: **0 220 460 B1**

# EUROPEAN PATENT SPECIFICATION

(45) Date of publication of patent specification: **11.12.91**   (51) Int. Cl.5: **H01L 25/10**

(21) Application number: **86112764.5**

(22) Date of filing: **16.09.86**

(54) Stacked module using standard integrated circuit chips.

(30) Priority: **30.10.85 US 792944**

(43) Date of publication of application:
**06.05.87 Bulletin 87/19**

(45) Publication of the grant of the patent:
**11.12.91 Bulletin 91/50**

(84) Designated Contracting States:
**DE FR GB IT**

(56) References cited:
**EP-A- 0 157 147**
**US-A- 4 398 235**

(73) Proprietor: **International Business Machines Corporation**
**Old Orchard Road**
**Armonk, N.Y. 10504(US)**

(72) Inventor: **Mueller, Wolfgang F.**
**61 Gold Road**
**Wappingers Falls, NY 12590(US)**
Inventor: **Spencer II, Gwynne W.**
**17 Round Hill**
**Poughkeepsie, NY 12603(US)**

(74) Representative: **Barth, Carl Otto et al**
**IBM Corporation Säumerstrasse 4**
**CH-8803 Rüschlikon(CH)**

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid (Art. 99(1) European patent convention).

## Description

### Background of the Invention

The present invention relates generally to packaging structures for integrated circuit devices or arrays and more particularly to a module configuration employing stacked industry standard chips.

Semiconductor integrated circuit memory chips are widely used in data processing systems ranging from personal computers to large mainframe systems. The memory chips typically comprise a packaged or encapsulated semiconductor memory array provided with a plurality of input/output pins, for example, in a dual-in-line package (DIP) arrangement of two parallel rows of pins. Perhaps the single most widely used chip is the read/write memory, also referred to as a dynamic random access memory (DRAM). The package dimensions and pin assignments for all memory chips having the same bit storage capacity are standardized so that the chips are interchangeable, regardless of the manufacturer.

To accommodate the need for increased storage density, it is known in the art to stack memory chips one atop another to double the storage density on a given printed circuit board. Within the required electrical, timing and thermal constraints, the corresponding address, power supply and data lines may be connected in parallel. Separate chip enable pin connections must be provided for each chip in order to select either the top or bottom chip. Examples of stacking arrangements for chips and other electronic packages are described, for example, in U.S. Patent Nos. 3,746,934; 4,018,494; 4,080,026; 4,364,620; and 4,406,508.

Two basic approaches have been used to achieve the advantage offered by stacking chips. The first approach involves the use of an interposer connector having a larger "footprint" than that of an individual chip, i.e., the interposer connector occupies a larger area on a printed circuit board or other structure on which the assembly is mounted. Since two chip select paths are required at every stacked chip location on the printed circuit board, the chip select pins from the upper and lower chips are routed to two separate locations on the interposer connector. For example, two standard 16 pin DRAMS may be mounted in an 18 pin socket, with the extra pin locations being used for the chip enable pins. A disadvantage of this approach is that it requires extra board space for the larger socket. In addition, a housing is typically required to provide the wiring paths from 16 to 18 pins, which increases cost and decreases the reliability of the stacked module arrangement.

In the second approach the pin assignments of one or both of the chips are rearranged from the industry standard to permit stacking. For example, in the case of a 64K DRAM, pin 1 is normally a no-connect or unused pin and pin 4 is a row address select or chip enable pin. One of the chips to be stacked may be customized so that pin 1 is the chip enable pin and pin 4 is the no-connect pin. The pins of the chips can then be directly paralleled. While this arrangement provides a 16 pin footprint on the printed circuit board, a customized chip is typically significantly more expensive than a standard chip, which makes the stacked arrangement less advantageous.

A more recent approach is described in the U.S. Patent application Serial No. 594,184, which was filed March 28, 1984. This document corresponds to EP-A-0 157 147. The disclosed structure includes a connector strap from the chip enable pin of the upper chip to the no-connect pin of the lower chip, the connector strap in one embodiment being placed between the two chips. The remaining pins are paralleled and soldered together. This arrangement, using industry standard chips, occupies the standard footprint and does not require a separate housing for the chips.

A memory chip currently in use is the 256K DRAM, which stores approximately 256,000 bits of data. The industry standard 256K chip is a 16 pin DIP made of plastic, ceramic, or plastic/ceramic. In the standard pin assignment all of the 16 pins are used, so that only the first known approach described above would be feasible for stacking two chips.

### Summary of the Invention

Accordingly, the present invention, as claimed, provides an improved module for stacking DIP integrated circuit chips and a memory board comprising a circuit board having a plurality of memory modules mounted thereon.

In one embodiment two industry standard memory chips having the same storage capacity and pin assignment are stacked to form a double density memory module. A connector strap extends from the chip enable pin of the upper chip, between the chips, and down one side of the lower chip to form a pin. The upper chip enable pin is electrically connected to the connector strap and the remaining pins on the upper chip are electrically connected to the corresponding pins on the lower chip, thus forming a stacked module having the same footprint as one of the standard chips, plus one additional pin.

According to another aspect of the invention the connector strap extends the length of the upper surface of the lower chip. One end of the connector strap is bent over one end of the lower chip, the other end of the strap being bent over the other end of the chip and extending downward to form the chip enable pin for the upper chip in the stacked module. A portion of the connector strap protrudes to form a connection to the chip enable pin of the upper chip. The strap is thus urged against the lower chip and held in place while the module is assembled.

It is therefore an object of the present invention to provide a stacked integrated circuit chip module which occupies the same area on a printed circuit board as that of one of the chips.

Another object of the invention is to provide a stacked module mountable on a printed circuit board, multilayer ceramic substrate or other second level package without a separate housing.

Still another object of the invention is to provide a stacked module which employs industry standard integrated circuit chips.

Brief Description of the Drawings

Other objects and many of the attendant advantages of the present invention will be better understood by reference to the following detailed description of preferred embodiments in conjunction with the accompanying drawings, wherein:

FIG. 1 is a diagrammatic view in perspective of the upper chip of a stacked module according to one embodiment of the present invention;

FIG. 2 is a diagrammatic view of an assembled stacked module;

FIG. 3 is a perspective view of a connector strap used in the stacked module of FIG. 2 according to another embodiment of the invention; and

FIG. 4 is a diagram of the pin assignment of a double density memory module according to FIG. 2.

Detailed Description of the Invention

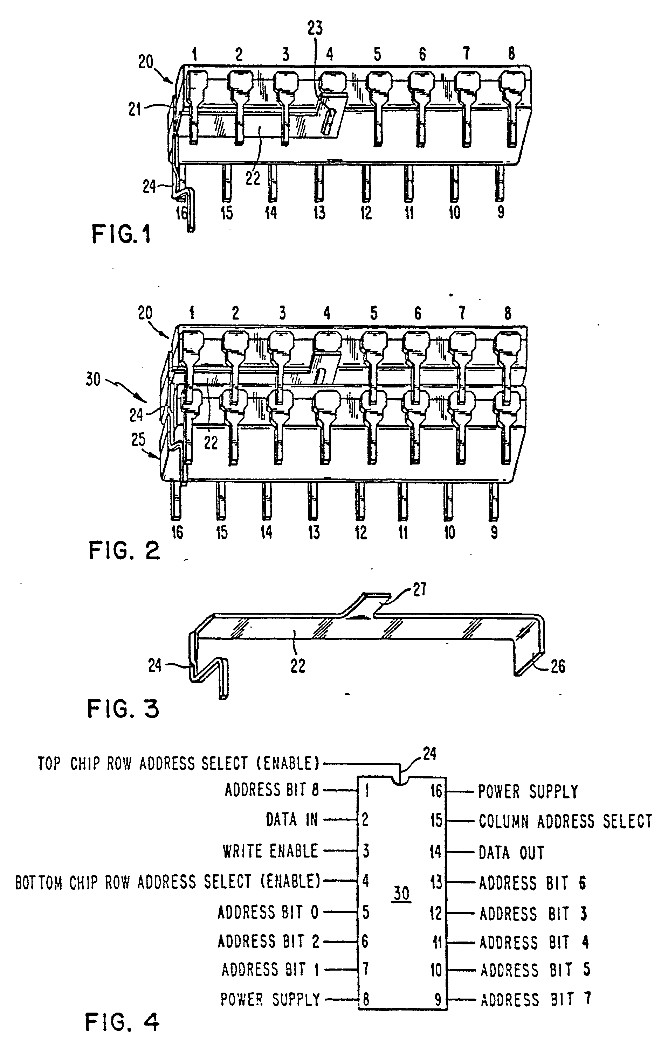

Referring now to the drawings, there is shown in FIG. 1 an upper chip 20 of a stacked module according to the present invention. By way of example to illustrate the principles of the present invention, upper chip 20 is shown with pins 1-16 which are labelled with reference to a notch 21 according to standard industry practice. It will be apparent to those skilled in the art that the present invention may be applied to chips having any number of pins in any configuration in order to stack chips having similar pin assignments. For an industry standard 256K DRAM chip, pin 4 of chip 20 is the chip select or enable pin. The remaining pins 1-3 and 5-16 have the functions as shown in FIG. 4, described below. A connector strap 22 positioned along the lower surface of chip 20 includes at one end a hole 23 aligned with pin 4, which is inserted therein and bent toward the body of chip 20 to form a mechanical and electrical connection to strap 22. This ensures that pin 4 does not make contact with the corresponding pin 4 of the lower chip when the chips are stacked, and that strap 22 is held in place. The other end of connector strap 22 is bent downward to form a section 24 which is the chip enable pin for upper chip 20. Strap 22 may be formed of any suitable metal having the required electrical and mechanical characteristics. In particular, a tin plated brass configuration is compatible with standard tin plated chip pins and with conventional lead-tin solders.

FIG. 2 shows the assembled stacked module 30 with a lower chip 25 in place. Section 24 of connector strap 22 is advantageously twisted, aligned with notch 21 of chip 25, and bent under the lower surface of the chip to hold it in place during assembly of the module. The lower end of section 24 is shown substantially parallel with pins 1-16 and coplanar with pins 1 and of chip 25, but it can be formed in various positions to be aligned with the desired location in a printed circuit board or the like to which module 30 is attached. To complete the assembly, chip 20 is positioned so that the pins of chip 20 contact the corresponding pins of chip 25, except for the chip enable (row address select) pin 4. Module 30 may then be dip soldered or wave soldered using a conventional process, which also solders strap 22 to pin 4 of chip 20. If a strap 22 without a hole 23 is abutted against pin 4, a high temperature solder process may first be used to solder the strap to pin 4. Chips 20 and 25 are then stacked and soldered together using a low temperature process to ensure that strap 22 is not disturbed.

It will be understood by those having skill in the art that other configurations of connector strap 22 are possible. For example, strap 22 can be located along the side or the top of chip 20 and section 24 of strap 22 can be located at either end of the chip. Further, instead of extending through a hole 23 in strap 22, the end of pin 4 can be cut off and bent over to contact the strap. An adhesive may also be employed to retain strap 22 in place against chip 20 prior to assembly of module 30. In yet another embodiment a conductive wire of the appropriate diameter and stiffness can be wrapped around pin 4, routed underneath or on top of chip 20, and extend downward over an end of chip 25 in the same manner as section 24 of strap 22.

Referring now to FIG. 3, there is shown another embodiment of the invention wherein connector strap 22 extends the full length of lower chip 25. The end of strap 22 opposite section 24 is bent to form a section 26 so that the strap is held in place when positioned over chip 25. A protrusion 27 intermediate end sections 24 and 26 of strap may be bent upwards and makes contact with pin 4 of chip 20 when the module is assembled.

FIG. 4 illustrates the pin assignments for a module 30 having a storage capacity of 512K when chips 20 and 25 are industry standard 256K DRAM chips. The pin labelled TOP CHIP ROW ADDRESS SELECT is the chip 20 enable pin, which is formed by section 24 of connector strap 22. The assembled module 30 may be mounted on a printed circuit board or other second level package in a conventional manner, with separate signal lines being routed to the upper chip 20 and lower chip 25 row address select pins.

While the illustrated embodiment shows a double density memory module, the present invention is not limited thereto. The term chip or integrated circuit chip as employed herein is intended to include such devices as read-write memories, static, programmable, or erasable programmable read-only memories, logic chips, programmable logic arrays and the like.

It will be understood that the stacked chips need not be identical, as long as both include a chip select pin and the function of each pin position is the same on both chips, i.e., the same pin positions are used for address, power supply, data, and enable. Thus, for example, a read-only memory (ROM) or a programmable read-only memory (PROM) may be stacked according to the present invention. The stacked chips need not even have the same number of pins or footprint size, as long as both chips include a chip select or enable pin and the function of each overlapping pin is the same on both chips.

While the invention has been shown and described with reference to particular embodiments thereof, it will be understood by those skilled in the art that various changes in form and details may be made without departing from the scope of the invention as set forth in the appended claims.

**Claims**

1.  A module (30) for stacking DIP integrated circuit chips comprising:

    a first DIP integrated circuit chip (20) mounted on top of a second DIP integrated circuit chip (25), each said chip including a chip select pin (4) and a plurality of other pins in the same pin positions on said first and second chips,

    characterized in that the pins on said first chip (20) are affixed to the corresponding pins on said second chip (25), except for said chip select pins (4); and

    connector means (22) are provided contacting said chip select pin (4) of said first chip (20) and extending downwards to form an additional output pin (24) from said module (30) so that said first and second chips (20, 25) are independently selectable.

2.  The module of claim 1 wherein said connector means (22) comprises:

    a conductive strap (22) located between the lower surface of said first chip (20) and the upper surface of said second chip (25), said strap (22) extending from said chip select pin (4) of said first chip (20), over one end of said second chip (25), and downward to form said additional output pin (24) of said module (30).

3.  The module of claim 2 wherein said first chip select pin (4) is bent under said first chip (20) to contact said conductive strap (22, 23, 27) without contacting said second chip select pin (4).

4.  The module of claim 2 or 3 wherein said conductive strap (22) extends the full length of said second chip (25) and the end (26) of said strap (22) opposite said additional output pin (24) of said module (30) is bent over the end of said second chip (25).

5.  The module of claim 1 wherein said connector means (22) comprises:

    a conductive strap (22) running along the upper surface of said first chip (20) and over one end thereof, then extending downward to a point below the lower surface of said second chip (25) to form said additional output pin (4) of said module.

6.  The module of claim 1 wherein wherein said connector means (22) comprises:

    a wire connected to said first chip select pin (4) and extending downward to form said additional output pin (24) of said module.

7.  The module of claim 6 wherein said wire runs between said first and second chips (20, 25) and extends over one end of said second chip (25).

8.  The module of any preceding claim wherein said first and second chips (20, 25) comprise memory devices.

9. The module of claim 8 wherein said memory devices are industry standard 256K dynamic random access memory chips and said module has a storage capacity of 512K.

10. The module of claim 8 wherein said memory devices are read-only memory chips.

11. The module of claim 8 wherein said memory devices are programmable array chips.

12. The module of claim 8 wherein said first chip (20) is a different type of memory device from said second chip (25).

13. A double density memory board comprising:

a circuit board having a plurality of mounting positions thereon; and

a plurality of memory modules (30) mounted in at least some of said mounting positions, each of said memory modules (30) comprising:

a first DIP integrated circuit memory chip (20) mounted on top of a second DIP integrated circuit memory chip (25), each said chip (20, 25) including a chip select pin (4) and a plurality of other pins in the same pin positions on said first and second chips (20, 25),

characterised in that the pins on said first chip (20) are affixed to the corresponding pins on said second chip (25), except for said chip select pins (4); and

connector means (22) are provided contacting said chip select pin (4) of said first memory chip (20) and extending downwards to form an additional output pin (24) from said memory module (30) so that said first and second memory chips (20, 25) are independently selectable.

**Revendications**

1. Module (30) pour l'empilage de puces de circuit intégré à double rangée de connexions, comprenant :
   une première puce de circuit intégré à double rangée de connexions (20) montée au-dessus d'une deuxième puce de circuit intégré à double rangée de connexions (25), chaque dite puce comportant une broche de sélection de puce (4) et une pluralité d'autres broches dans les mêmes positions de broche sur lesdites première et deuxième puces,
   caractérisé en ce que

les broches sur ladite première puce (20) sont fixées aux broches correspondantes de ladite deuxième puce (25), à l'exception desdites broches de sélection de puce (4) ; et
   des moyens de connexion (22) sont prévus en contact avec ladite broche de sélection de puce (4) de ladite première puce (20) et s'étendant vers le bas pour former une broche de sortie supplémentaire (24) dudit module (30) , de sorte qu'on peut sélectionner indépendamment lesdites première et deuxième puces (20,25).

2. Module suivant la revendication 1, dans lequel lesdits moyens de connexion (22) comprennent une bande conductrice ou cavalier (22) placé entre la surface inférieure de ladite première puce (20) et la surface supérieure de ladite deuxième puce (25), ledit cavalier (22) partant de ladite broche de sélection de puce (4) de ladite première puce (20),passant sur une extrémité de ladite deuxième puce (25) et s'étendant vers le bas pour former ladite broche de sortie supplémentaire (24) dudit module (30).

3. Module suivant la revendication 2, dans lequel ladite broche (4) de sélection de la première puce est pliée sous ladite première puce (20) pour venir en contact avec ledit cavalier (22,23,27) sans venir en contact avec ladite broche (4) de sélection de la deuxième puce.

4. Module suivant la revendication 2 ou 3, dans lequel ledit cavalier (22) s'étend sur toute la longueur de ladite deuxième puce (25), et l'extrémité (26) dudit cavalier (22) opposée à ladite broche de sortie supplémentaire (24) dudit module (30) est pliée sur l'extrémité de ladite deuxième puce (25).

5. Module suivant la revendication 1, dans lequel lesdits moyens de connexion (22) comprennent une bande conductrice ou un cavalier (22) s'étendant le long de la surface supérieure de ladite première puce (20) et sur une extrémité de celle-ci, puis s'étendant vers le bas jusqu'à un point situé plus bas que la surface inférieure de ladite deuxième puce (25) pour former ladite broche de sortie supplémentaire (4) dudit module.

6. Module suivant la revendication 1, dans lequel lesdits moyens de connexion (22) comprennent un fil connecté à ladite broche (4) de sélection de la première puce et s'étendant vers le bas pour former ladite broche de sortie supplémentaire (24) dudit module.

7. Module suivant la revendication 6, dans lequel ledit fil passe entre lesdites première et deuxième puces (20,25) et s'étend sur une extrémité de ladite deuxième puce (25).

8. Module suivant l'une quelconque des revendications précédentes, dans lequel lesdites première et deuxième puces (20,25) comprennent des dispositifs de mémoire.

9. Module suivant la revendication 8, dans lequel lesdits dispositifs de mémoire sont des puces de mémoire vive dynamique de 256K normalisées dans l'industrie et ledit module possède une capacité de stockage de 512K.

10. Module suivant la revendication 8, dans lequel lesdits dispositifs de mémoire sont des puces de mémoire morte.

11. Module suivant la revendication 8, dans lequel les dispositifs de mémoire sont des puces de réseau programmable.

12. Module suivant la revendication 8, dans lequel ladite première puce (20) est un dispositif de mémoire de type différent de celui de ladite deuxième puce (25).

13. Carte de mémoire de densité double comprenant :

une carte de circuit comportant une pluralité de positions de montage ; et

une pluralité de modules de mémoire (30) montés dans au moins certaines desdites positions de montage, chacun desdits modules de mémoire (30) comprenant :

une première puce de mémoire à circuit intégré à double rangée de connexions (20) montée au-dessus d'une deuxième puce de mémoire à circuit intégré à double rangée de connexions (25), chaque dite puce (20,25) comportant une broche de sélection de puce (4) et une pluralité d'autres broches dans les mêmes positions de broche sur lesdites première et deuxième puces (20,25), caractérisée en ce que

les broches sur ladite première puce (20) sont fixées aux broches correspondantes sur ladite deuxième puce (25), à l'exception desdites broches de sélection de puce (4) ; et

des moyens de connexion (22) sont prévus en contact avec ladite broche de sélection de puce (4) de ladite première puce de mémoire (20) et s'étendant vers le bas pour former une broche de sortie supplémentaire (24) du dit module de mémoire (30) de sorte qu'on peut sélectionner indépendamment lesdites première et deuxième puces de mémoire (20,25).

**Patentansprüche**

1. Modul (30) zum Stapeln (DIP) integrierter Schaltungschips, wobei der Modul umfaßt:

ein erstes DIP integriertes Schaltungschip (20), das auf einem Zweiten DIP integrierten Schaltungschip (25) montiert ist, und jedes Chip einen Kontaktstift (4) zur Chipauswahl einschließt und eine Vielzahl anderer Kontaktstifte in den gleichen Positionen auf dem ersten und zweiten Chip,

dadurch gekennzeichnet, daß die Kontaktstifte auf dem ersten Chip (20) an den entsprechenden Kontaktstiften des zweiten Chips (25) befestigt sind mit Ausnahme der Kontaktstifte (4) für die Chipauswahl und daß

eine Anschlußvorrichtung (22) vorgesehen ist, die den Kontaktstift (4) für die Chipauswahl des ersten Chips (20) kontaktiert und sich nach unten erstreckt, um einen zusätzlichen Ausgangsanschlußstift (24) des Moduls (30) zu bilden, so daß das erste und das zweite Chip (20, 25) unabhängig auswählbar sind.

2. Modul nach Anspruch 1, bei dem die Anschlußvorrichtung (22) umfaßt:

einen leitenden Streifen (22), der zwischen der Unterseite des ersten Chips (20) und der Oberseite des zweiten Chips (25) angeordnet ist und sich von dem Kontaktstift (4) zur Chipauswahl des ersten Chips (20) über ein Ende des zweiten Chips (25) und nach unten erstreckt, um den zusätzlichen Ausgangsanschlußstift (24) des Moduls (30) zu bilden.

3. Modul nach Anspruch 2, bei dem der Anschlußstift (4) zur Auswahl des ersten Chips unter das erste Chip (20) abgebogen ist, um den leitenden Streifen (22, 23, 27) Zu kontaktieren, ohne den Anschlußstift (4) zur Auswahl des zweiten Chips zu berühren.

4. Modul nach Anspruch 2 oder 3, bei dem der leitende Streifen (22) sich über die volle Länge des zweiten Chips (25) erstreckt und das Ende (26) des Streifens (22), das dem zusätzlichen Ausgangsanschlußstift (24) des Moduls (30) gegenüberliegt, über das Ende des zweiten Chips (25) gebogen ist.

5. Modul nach Anspruch 1, bei dem die Anschlußvorrichtung (22) umfaßt:

einen leitenden Streifen (22), der an der Oberseite des ersten Chips (20) entlang läuft und über dessen eines Ende, dann sich abwärts erstreckt zu einem Punkt unter der Unterseite des zweiten Chips (25), um den zusätzlichen Ausganganschlußstift (4) des Moduls zu bilden.

6. Modul nach Anspruch 1, bei dem die Anschlußvorrichtung (22) umfaßt:

einen Draht, der mit dem ersten Anschlußstift (4) zur Auswahl des ersten Chips verbunden ist und sich abwärts erstreckt, um den zusätzlichen Ausgangsanschlußstift (24) des Moduls zu bilden.

7. Modul nach Anspruch 6, bei dem der Draht zwischen dem ersten und zweiten Chip (20, 25) verläuft und sich über ein Ende des zweiten Chips (25) erstreckt.

8. Modul nach einem der vorhergehenden Ansprüche, bei dem das erste und zweite Chip (20, 25) Speicherbausteine enthalten.

9. Modul nach Anspruch 8, bei dem die Speicherbausteine dem Industriestandard entsprechende 256K dynamische Speicherchips mit wahlfreiem Zugriff sind und der Modul eine Speicherkapazität von 512K aufweist.

10. Modul nach Anspruch 8, bei dem die Speicherbausteine Festwertspeicherchips sind.

11. Modul nach Anspruch 8, bei dem die Speicherbausteine programmierbare Matrixchips sind.

12. Modul nach Anspruch 8, bei dem das erste Chip (20) eine vom zweiten Chip (25) verschiedene Art des Speicherbausteins ist.

13. Eine Platine für einen Speicher mit verdoppelter Dichte, enthaltend:

eine Schaltungsplatine mit einer Vielzahl von Montagepositionen darauf und

eine Vielzahl von Speichermodulen (30), die zumindest in einigen der Montagepositionen montiert sind, wobei jeder der Speichermodule (30) umfaßt:

ein erstes DIP Speicherchip (20), das auf einem zweiten DIP Speicherchip (25) montiert ist, wobei jedes Chip (20, 25) einen Anschlußstift (4) zur Chipauswahl und eine Vielzahl anderer Anschlußstifte in den gleichen Stiftpositionen auf dem ersten und zweiten Chip (20, 25) einschließt,

dadurch gekennzeichnet, daß die Anschlußstifte auf dem ersten Chip (20) an den entsprechenden Anschlußstiften auf dem zweiten Chip (25) befestigt sind mit Ausnahme der Anschlußstifte zur Chipauswahl und

daß eine Anschlußvorrichtung (22) vorgesehen ist, die den Anschlußstift (4) zur Chipauswahl des ersten Speicherchips (20) kontaktiert und sich abwärts erstreckt, um einen zusätzlichen Ausgangsanschlußstift (24) des Speichermoduls (30) zu bilden, so daß das erste und zweite Speicherchip (20, 25) unabhängig auswählbar sind.

FIG. 1

FIG. 2

FIG. 3

TOP CHIP ROW ADDRESS SELECT (ENABLE) ——— 24

| | | |
|---|---|---|
| ADDRESS BIT 8 — | 1 | 16 — POWER SUPPLY |
| DATA IN — | 2 | 15 — COLUMN ADDRESS SELECT |
| WRITE ENABLE — | 3 | 14 — DATA OUT |
| BOTTOM CHIP ROW ADDRESS SELECT (ENABLE) — | 4 | 13 — ADDRESS BIT 6 |
| ADDRESS BIT 0 — | 5 (30) | 12 — ADDRESS BIT 3 |
| ADDRESS BIT 2 — | 6 | 11 — ADDRESS BIT 4 |
| ADDRESS BIT 1 — | 7 | 10 — ADDRESS BIT 5 |
| POWER SUPPLY — | 8 | 9 — ADDRESS BIT 7 |

FIG. 4